# EUROPEAN PATENT APPLICATION

(11) **EP 1 923 482 A1**
(43) Date of publication of application: **21.05.2008**
(21) Application number: 07250683.5
(22) Date of filing: 19.02.2007
(51) Int. Cl.: C23C 14/35, G01R 33/02, H01J 37/34, G01R 33/10

(54) **Method and apparatus for automation of PTF measurement in sputter targets**

(30) Priority: 20.11.2006 US 601791
(71) Applicant: Heraeus, Inc., Chandler AZ 85226 (US)
(72) Inventor: Rogers, Raymond D, Phoenix, AZ 85019 (US)
(74) Representative: Hill, Justin John

(57) **Abstract**

The present invention is directed towards an automated apparatus and method for determining the pass through flux (PTF) of a sputter target by generating a magnetic field on a first side of the sputter target and passing the magnetic field through the sputter target and out a second side of the sputter target, measuring the magnetic field at the second side of the sputter target with a magnetic field detector, and moving one or both the sputter target or the magnetic field detector during the measuring using an automated stand. In various embodiments of the present invention, the automated apparatus and method may generate a map of the sputter target.

## Description

### BACKGROUND

### Field

The present invention is directed to a method and apparatus for measuring the Pass Through Flux (PTF) properties of a sputter target. More particularly, the present invention relates to a method and apparatus for automated PTF measurement in sputter targets.

### Background

Sputtering processes are widely used for the deposition of thin films of material onto desired substrates. A typical sputtering system includes a source for generating an electron or ion beam, a target that comprises a material to be atomized and a substrate onto which the sputtered material is deposited. The process involves bombarding the target material with an electron or ion beam at an angle that causes the target material to be sputtered or eroded. The sputtered target material is deposited as a thin film or layer on the substrate. The target materials for sputtering process range from pure metals to ever more complicated alloys.

Magnetron sputtering involves the arrangement of permanent or electromagnets behind a target material (cathode), and applying a magnetic field to the target. The applied magnetic field transmits through the target and focuses a discharge plasma onto the front of the target. The target front surface is atomized with subsequent deposition of the target atoms on top of an evolving thin film device positioned adjacent to the target.

Magnetron sputtering of magnetic target materials is very prevalent in the electronics industry, particularly in the fabrication of semiconductor and data storage devices. Due to the soft magnetic nature of magnetic target alloys, there is considerable shunting of the applied magnetic field in the bulk of the target. This in turn results in reduced target utilization due to focusing of the transmitted magnetic field in the erosion groove formed as a result of the shunting. This focusing effect is exacerbated with increasing material permeability (which corresponds to decreasing material PTF).

Reducing target material permeability promotes a less severe erosion profile which enhances target material utilization and subsequently contributes to a reduction in material cost. The presence of severe target erosion profiles also promotes a point source sputtering phenomena which can result in less than optimum deposited film thickness uniformity. Therefore, decreasing target material permeability has the added benefit of increasing deposited film thickness uniformity.

The PTF of a sputter target is defined as the ratio of transmitted magnetic field to applied magnetic field. A PTF value of 100% is indicative of a non-magnetic material where none of the applied field is shunted through the bulk of the target. The PTF of magnetic target materials is typically specified in the range of 0 to 100%, with the majority of commercially produced materials exhibiting values between 30 to 100%.

There are several different techniques for measuring PTF. One technique involves placing a 4.4 (+/-0.4) kilogauss bar magnet in contact on one side of the target material and monitoring the transmitted field using an axial Hall probe in contact on the other side of the target material. The maximum value of the magnetic field transmitted through the bulk of the target divided by the applied field strength in the absence of the target between the magnet and probe (maintained at the same distance apart as when the target was between them) is defined as the PTF. PTF can be expressed as either a fraction or a percent.

Another technique for measuring PTF involves using a horseshoe magnet and a transverse Hall probe. The PTF values measured using different magnet and probe arrangements are found to exhibit good linear correlation for the values of magnet field strength typically utilized in the industry. The PTF measurement techniques are constructed to approximate the applied magnetic flux occurring in an actual magnetron sputtering machine. Therefore, PTF measurements have direct applicability to a target material's performance during magnetron sputtering.

Magnetic material PTF and permeability are not mutually exclusive. Rather, there is a very strong inverse correlation between PTF and maximum permeability of magnetic materials. Values of material magnetic permeability can be very precisely determined by using vibrating-sample-magnetometer (VSM) techniques in accordance with ASTM Standard A 894-89.

Presently, PTF measurement is performed with manually operated PTF stands. The ASTM F 1761-00 and ASTM F 2086-01 standards set forth test methods for pass through magnetic flux. Targets are manually rotated 30, 60, 90, and 120 degree orientations, and the magnetic field values are manually measured and recorded at each angular setting. The test fixtures specified by these standards, which primarily differ with respect to the orientation of the horseshoe-style magnet relative to the target under test, must be manually adjusted by an operator. Because of the manual setup and operation of the PTF test fixture, it is difficult and time consuming to make extensive measurements to accurately characterize the PTF over the sputter target. Accordingly, because of limited measurement of a target, an operator can fail to detect defects that could exist on a particular portion of a sputter target. Moreover, typical manual sputter target test fixture stands hold a sputter target directly on the surface of a target table. Thus, during a measurement process using a typical manual test fixture, the surface of a sputter target can be scratched by the surface of the target table during the rotation of the target for each of the angular positions.

Accordingly, what is needed is an apparatus and method that automates PTF measurement for sputter targets. Additionally what is needed is an automated PTF measurement apparatus and method capable of generate a map of a measured sputter target. What is further needed is an automated PTF measurement apparatus that allows for rotation of a sputter target during measurement, but does not scratch its surface.

### SUMMARY

The various embodiments of the present invention address the above-described deficiencies of typical PTF measurement systems and methods. Exemplary embodiments of the present invention relate to an apparatus for determining the PTF of a sputter target having a magnetic source generating a magnetic field passing through the sputter target, a magnetic field detector configured to measure the magnetic field, and an automated stand configured to move one or both of the sputter target or the magnetic field detector. In addition, exemplary embodiments of the present invention relate to a method for determining the PTF of a sputter target by generating a magnetic field on a first side of the sputter target and passing the magnetic field through the sputter target and out a second side of the sputter target, measuring the magnetic field at the second side of the sputter target with a magnetic field detector, and moving one or both the sputter target or the magnetic field detector during the measuring using an automated stand.

Various embodiments of the present invention measure the magnetic field transmitted through a sputter target. The PTF is a magnetic field transmitted through a ferromagnetic sputter target, from one face to the opposite face. The source magnetic field is in the test target's radial direction. The reference field is the magnetic field measured with the magnetic field detector when no sputtering target is in position on the test stand. The strength of the field depends upon the height and position of the magnetic field detector relative to the source magnet. The source field is the magnetic field measured with the magnetic field detector at the top surface of the automated target support table.

The sputter target under test is mounted between at least one drive wheel and at least two idler wheels above the top surface of the automated test fixture apparatus. Sputter targets of various diameters and thickness are accommodated by the automated PTF measurement apparatus to align the target under test with the source magnet mounted in the test fixture. The automated PTF measurement apparatus has permanent horseshoe-shaped magnet mounted to a rotatable base that is located below a face of the sputter target. A magnetic field detector is used to measure the magnetic field penetrating the sputter target and entering the space from the target's opposite face.

In various embodiments of the invention, a computer determines the percentage of the magnetic field transmitted through the target (percent PTF) for each of the individual PTF readings by dividing by the reference magnetic field and multiplying this quotient by 100. The data is analyzed by the computer to identify the maximum and minimum PTF percentages. The processor also averages the percent PTF values to determine the average percent PTF. Also, in various embodiments of the invention, for each target tested, the percent PTF value measured at each position and orientation angle of the target is stored in a data storage device or database, and can be displayed to an operator. For each target tested, the average of the percent PTF can be displayed to the operator, as well as stored in a data storage device or database. In various embodiments, the computer identifies the maximum and minimum percent PTF values, as well and their location on the target. The range of percent PTF values collected from the target and their location are computed and reported to an operator on a display screen. In some embodiments, the computer can calculate the range divided by the average, and report the results to an operator. These results can also be stored in a data storage device or database.

The advantages of the exemplary embodiments of the invention described herein include automated control of the operation of the sputter target location relative to the magnet and the magnetic field detector. The exemplary embodiments of the invention also include the advantage of accuracy and repeatability of PTF measurement in sputter targets. In addition, automated PTF measurement minimizes manual labor previously associated with PTF measurements. Automated control of PTF measurement of a sputter target using processor and digital data storage systems of databases provide digital storage of data collected during the measurement process. In addition, the processor can utilize the data to accurately map the PTF characteristics of the sputter target and present them to an operator. Furthermore, the automated PTF measurement apparatus holds the sputter target above target table by at least one drive wheel and at least two idler wheels, thus preventing scratching of the surface of the sputter target by the target table.

It is understood that other embodiments of the present invention will become readily apparent to those skilled in the art from the following detailed description, wherein it is shown and described only various embodiments of the invention by way of illustration. As will be realized, the invention is capable of other and different embodiments and its several details are capable of modification in various other respects, all without departing from the spirit and scope of the present invention. Accordingly, the drawings and detailed description are to be regarded as illustrative in nature and not as restrictive.

### BRIEF DESCRIPTION OF THE DRAWINGS

Referring now to the drawings in which like reference numbers represent corresponding parts throughout:

FIG. 1 illustrates a right side schematic view of a computer controlled PTF measurement apparatus according to various embodiments of the present invention.

FIG. 2 illustrates a left side schematic view of a computer controlled PTF measurement apparatus according to various embodiments of the present invention.

FIG. 3 illustrates a partial schematic view of a computer controlled PTF measurement apparatus according to various embodiments of the present invention, showing a moveable magnetic field detector assembly.

FIG. 4 illustrates a partial side schematic view of a computer controlled PTF measurement apparatus according to various embodiments of the present invention, showing traverse and rotation motors and related gearing.

FIG. 5A illustrates a left side schematic view of a rotation gearing assembly of a computer controlled PTF measurement apparatus according to various embodiments of the present invention.

FIG. 5B illustrates a top schematic view of a rotation gearing assembly of a computer controlled PTF measurement apparatus according to various embodiments of the present invention.

FIG. 5C illustrates swivel arm movement of a rotation gearing assembly of a computer controlled PTF measurement apparatus according to various embodiments of the present invention.

FIG. 5D illustrates a bottom schematic view of a rotational gearing assembly of a computer controlled PTF measurement apparatus according to various embodiments of the present invention.

FIG. 6 illustrates a top schematic view of a computer controlled PTF measurement apparatus according to various embodiments of the present invention.

FIG. 7 illustrates a partial schematic view of a computer controlled PTF measurement apparatus according to various embodiments of the present invention, showing an exemplary sputter target relative to a magnetic source and magnetic field detector.

FIG. 8 illustrates a diagram of the computer control system to control the operation of the PTF measurement apparatus according to various embodiments of the present invention.

FIG. 9 illustrates an exemplary method for automated PTF measurement according to various embodiments of the present invention.

FIG. 10 illustrates an exemplary method for automated PTF measurement of a sputter target and mapping the results according to various embodiments of the present invention.

FIG. 11 illustrates an exemplary PTF measurement map for an analyzed sputter target according to various aspects of the present invention.

### DETAILED DESCRIPTION

The detailed description set forth below in connection with the appended drawings is intended as a description of various embodiments of the invention and is not intended to represent the only embodiments in which the invention may be practiced. The detailed description includes specific details for the purpose of providing a thorough understanding of the invention. However, it will be apparent to those skilled in the art that the invention may be practiced without these specific details. In some instances, well known structures and components may be shown in block diagram form or partial schematic view in order to avoid obscuring the concepts of the invention.

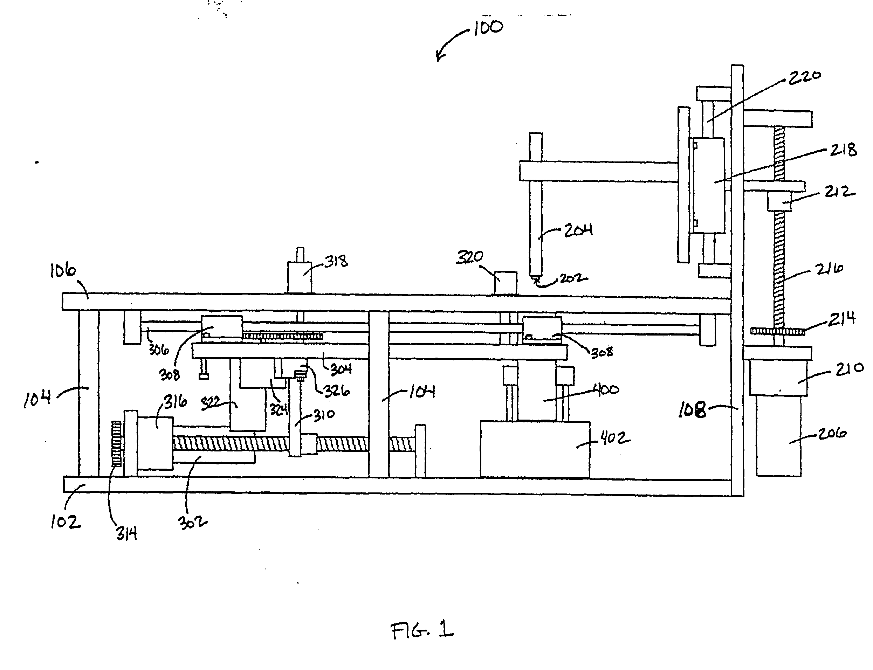

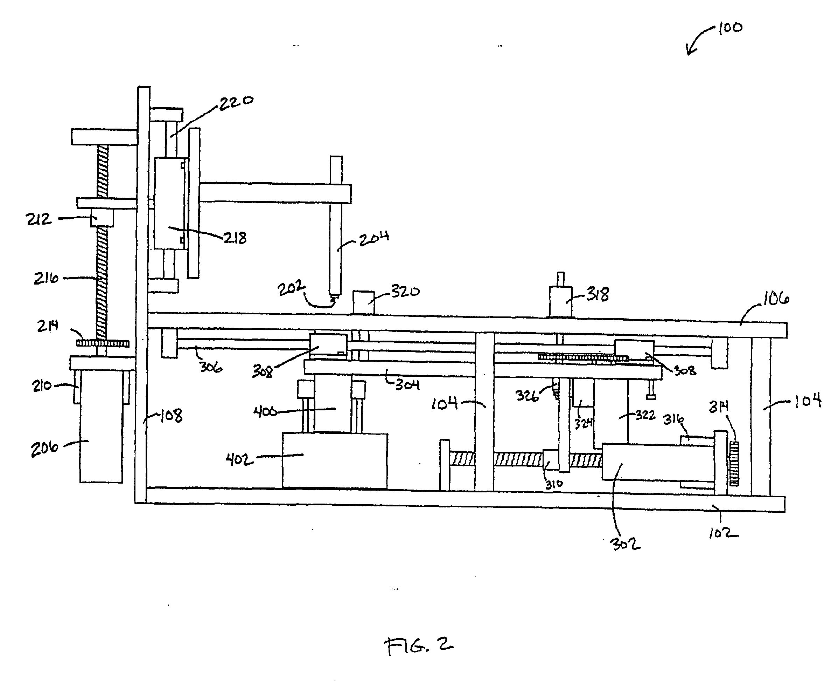

FIG. 1 illustrates a right side schematic view and FIG. 2 illustrates left side schematic view of a computer controlled PTF measurement apparatus 100 according to various embodiments of the present invention.

Computer controlled PTF measurement apparatus 100 has base plate 102. Table support structures 104 are connected to base plate 102 on one end and target table 106 on the opposite end, with base plate 102 and support structures 104 supporting target table 106. Probe slide rod support structure 108 is also connected to base plate 102 and assists in supporting target table 106, in a similar manner to table support structures 104. In various embodiments, the structural elements of the apparatus (e.g., base plate 102, table support structures 104, target table 106, probe slide rod support structure 108, etc.) utilize non-magnetic materials to allow operation of the apparatus without affecting the magnetic properties of the source magnet (e.g., source magnet 400).

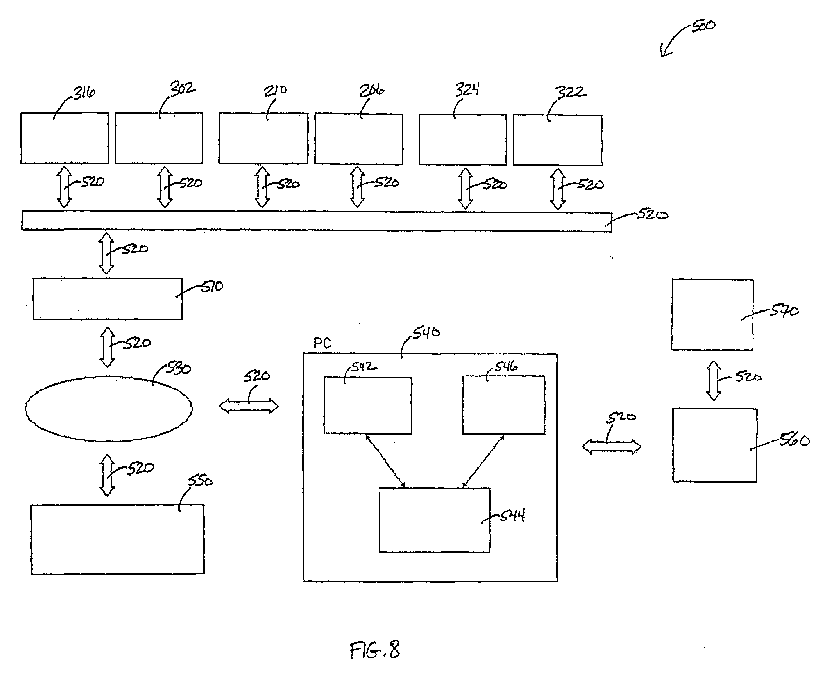

Computer controlled PTF measurement apparatus 100 enables the movement of a magnetic field detector for measuring the PTF of sputter targets. Magnetic field detector 202 is located within magnetic field detector holding mechanism 204. Magnetic field detector 202 can be a Gaussmeter, Teslameter, or any other suitable magnetic field measurement device. In some exemplary embodiments, such as those illustrated in FIG. 8, the magnetic field detector may be comprised of both a magnetic field probe for detecting a magnetic field and a Gaussmeter or Teslameter for performing measurement of the magnetic field.

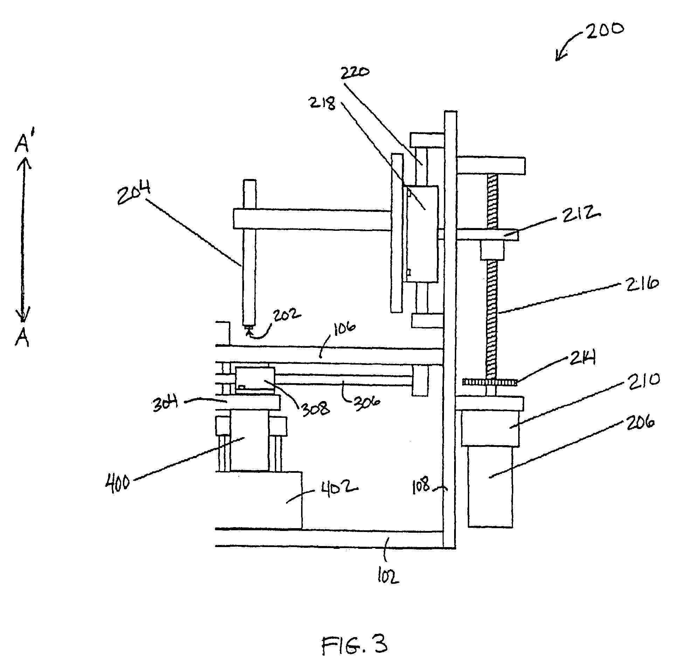

FIG. 3 illustrates a partial schematic view of computer controlled PTF measurement apparatus 100 showing a moveable magnetic field detector assembly 200. Magnetic field detector 202 can be moved in a vertical plane in the A or A' directions to be located in a position to measure a sputter target located on or above target table 106. Adjustment motor 206, which is controlled by computer 540 of FIG. 8, powers the movement of magnetic field detector 202 in the A or A' direction.

Magnetic field detector adjustment arm 212 is connected to slide rod bearing assembly 218. Slide rod bearing assembly 218 is suspended from slide rod 220, which is affixed to slide rod support structure 108. Slide rod bearing assembly 218 can move in a vertical direction along slide rod 220, and is guided by magnetic field detector adjustment arm 212. As adjustment motor 206 turns gear 214, adjustment lead screw 216 rotates and moves magnetic field detector adjustment arm 212 in the A or A' direction. Accordingly, as adjustment motor 206 rotates gear 214 to rotate adjustment lead screw 216, magnetic field detector adjustment arm 212 moves slide rod bearing assembly 218 along slide rod 220. As magnetic field detector holding mechanism 204 is connected to slide rod bearing assembly 218, magnetic field detector 202 is able to move in the A direction, and if adjustment motor 206 is reversed, magnetic field detector 202 moves in the A' direction.

Additionally, as adjustment motor 206 drives the movement of probe adjustment arm 212 in the A or A' directions, encoder 210 tracks the movement of magnetic field detector 202. Adjustment motor 206 can have a home switch that can be enabled by the movement of slide rod bearing assembly 218 along slide rod 220 into at least one predetermined position to initialize the start position of adjustment motor 206 prior to any movement or measurement of the sputter target. Thus, encoder 210 records the initial position, as well as the movement of adjustment motor 206.

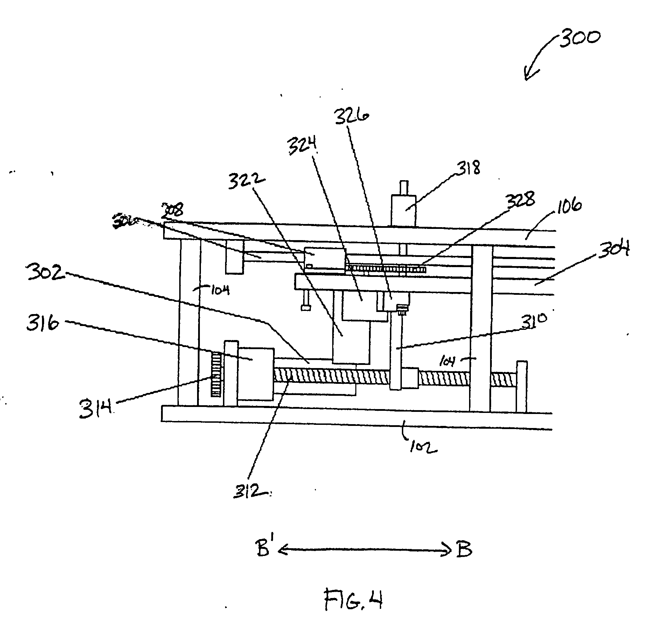

FIG. 4 illustrates a partial side schematic view of traverse and rotation assembly 300 of computer controlled PTF measurement apparatus 100. Upon receiving commands from computer 540, traverse motor 302 can move rotation plate 304 in the B or B' directions to locate a sputter target beneath magnetic flux detector and above magnetic source to perform PTF measurements.

Rotation plate traverse slide 306 is mounted below target table 106. Rotation plate 304 is coupled to rotation plate traverse slide bearing assembly 308, which is suspended from rotation plate traverse slide 306. This arrangement allows rotation plate 304 to move in the B or B' direction along rotation plate traverse slide 306. Traverse rotation plate arm 310 is attached to rotation plate 304 on one end and traverse lead screw 312 on the opposite end. Traverse motor 302 rotates traverse gearing 314, which interfaces with traverse lead screw 312 to move traverse rotation plate arm 310 and rotation plate 304.

Traverse motor 302 can have a home switch that can be enabled to initialize the start position of traverse motor 302 prior to any movement or measurement of the sputter target. The home switch of traverse motor 302 may be activated to initialize the start position by the movement of traverse slide bearing assembly 308 on rotation plate traverse slide 306 to at least one predetermined position. Upon receipt of a command from computer 540, traverse motor 302 turns traverse gear 314. Traverse encoder 316 records the initial position, as well as the movement of traverse motor 302. Accordingly, as traverse motor 302 drives the movement of traverse rotation plate arm 310 in the B or B' directions, traverse encoder 316 tracks the movement of rotation plate 304.

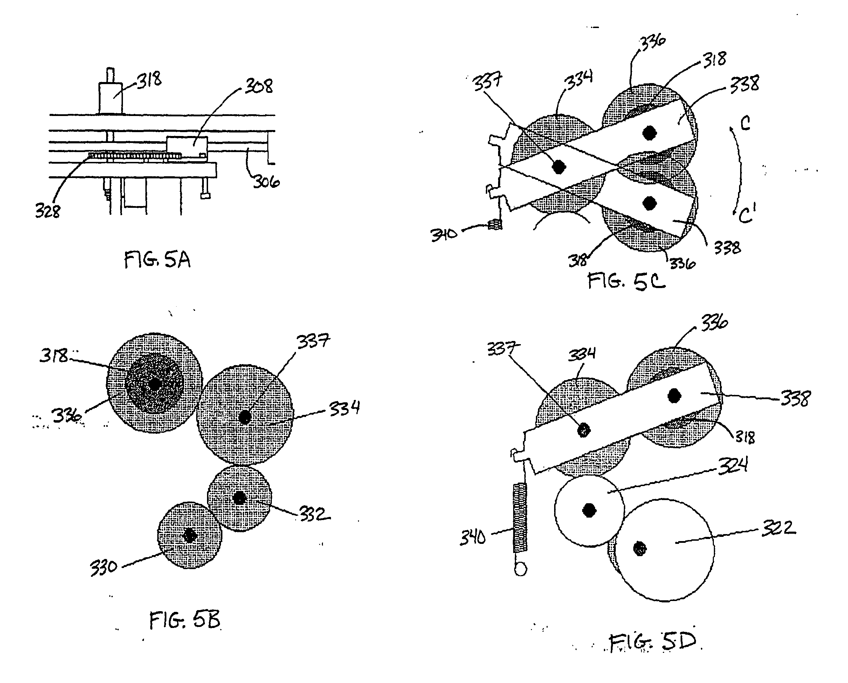

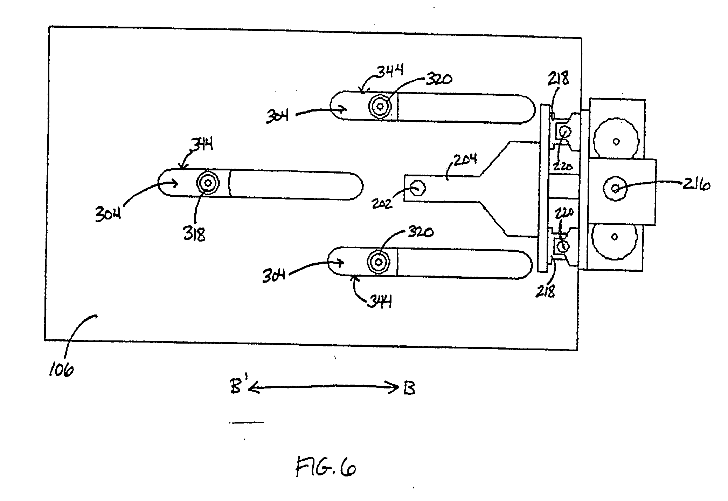

Drive wheel 318 and idler wheels 320, which are capable of holding sputter targets of various sizes, are rotatably connected to a top side of rotation plate 304. Although only one drive wheel is illustrated in FIG. 1, FIG. 2, and FIGS. 4-7 (e.g., drive wheel 318), additional drive wheels could be used to hold or rotate the sputter target. Additional drive gearing may be added as necessary to supply power from rotation motor 322 to the additional drive wheels. Similarly, there may be at least two idler wheels used to hold the sputter target. Oval-shaped cutouts (e.g., oval-shaped cutouts 344 as illustrated in FIG. 6) in target table 106 allow for the pass-through of drive wheel 318 and idler wheels 320. Additional oval shaped cutouts may be added as additional drive wheels or idler wheels are added. Rotation motor 322 and rotation encoder 324 are affixed below rotation plate 304. Swivel adjustment 326 allows for movement of drive wheel 318 (e.g., movement in the C or C' directions illustrated in FIG. 5C) to permit different size sputter targets to be placed within contact of drive wheel 318 and at least two idler wheels 320. Additional swivel adjustment devices may be added to accommodate additional drive wheels. Drive gearing 328 rotates drive wheel 318 to rotate the sputter target to permit different PTF measurements at predetermined orientations.

FIGS. 5A-5D more particularly illustrate exemplary embodiments for the operation of drive gearing 328 that is driven by rotation motor 322. As noted above, additional drive gearing may be needed to accommodate additional drive wheels. Drive gear 330, which is coupled to rotation motor 322, interfaces with drive gear 332, which is attached to rotation encoder 324. Rotation encoder 324 tracks the movement of rotation motor 322 and drive wheel 318, and transmits this data to computer 540. Drive gear 332 interfaces with drive gear 334, which rotates about swivel post axis 337 (see FIG. 5B). Drive gear 334 interfaces with drive gear 336, with drive gear 336 being coupled below drive wheel 318. This exemplary arrangement of drive gears 330, 332, 334, 336 permits rotation motor 332 to turn drive wheel 318 to rotate a sputter target, and additionally permits movement of drive wheel 318 in an arc in the C or C' direction to accommodate different sized sputter targets.

Turning to FIGS. 5C and 5D, drive gear 334 and drive gear 336 (as well as drive wheel 318 which is affixed to drive gear 336) rotate about axes that are affixed to the swivel arm 338, which rotates about swivel post axis 337. Tension spring 340, which is affixed to the bottom of rotation plate 304 on one end and to swivel arm 338 on the opposite end, creates mechanical tension such that drive wheel 318 has mechanical contact with sputter target 342. Swivel arm 338 can rotate in the C or C' direction as illustrated in FIG. 5C. Movement of swivel arm 338 allows for different size sputter targets to be accommodated by computer controlled PTF apparatus 100. Additional swivel arms may be added to accommodate additional drive wheels. Drive wheel 318 and idler wheels 320 have a circumferential "lip", which the sputter target (e.g. sputter target 342) can be located on. In this manner, a sputter target (e.g., sputter target 342) can be located above target table 106 on the circumferential lip portions of drive wheel 318 and idler wheel 320 so the sputter target is not scratched by target table 106 during rotation of the target.

FIG. 6 illustrates a top view of computer controlled PTF apparatus 100. Oval-shaped cutouts 344 in target table 106 permit drive wheel 318 and idler wheels 320, which are mounted on rotation plate 304 to be located above the surface of target table 106 and hold a sputter target. Oval-shaped cutouts 344 allow rotation plate 304 (located below target table 106) with drive wheel 318 and idler wheels 320 to be moved in the B or B' direction, so as to accommodate different size sputter targets and to allow for measurements at different locations on a given sputter target. Movement of rotation plate 304 in the B or B' direction allows computer controlled PTF apparatus 100 to position a particular portion of a sputter target to be tested below magnetic field detector 202.

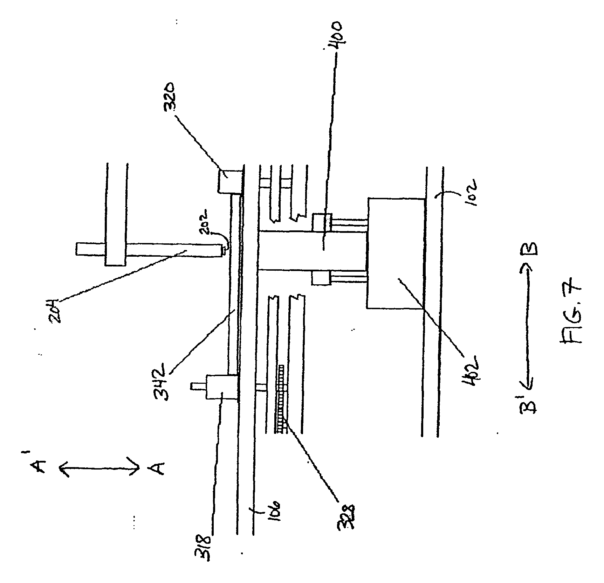

Turning to FIG. 7, an exemplary sputter target 342 is positioned between magnetic source 400 and magnetic field detector 202. Magnetic source 400 is connectively coupled to rotatable pedestal 402, with rotatable pedestal 402 being coupled to base plate 102. Magnetic source 400 is preferably a horseshoe-style magnet. An operator of computer controlled PTF apparatus 100 can rotate magnetic source 400, for example, to carry out similar test as those described by ASTM 1761 or ASTM 2086. Sputter target 342 is preferably held by drive wheel 318 and idler wheels 320. This arrangement allows sputter target 342 to be rotated by movement of drive wheel 318 (and corresponding movement of idler wheels 320), while not having direct contact with target table 106 which could scratch sputter target 342 during the rotation. As discussed above in connection with FIG. 4, rotation plate 304 can be moved horizontally in the B or B' direction to further position sputter target 342 below magnetic field detector 202. Magnetic field detector can be moved vertically in the A or A' direction relative to sputter target 342 and magnetic source 400.

FIG. 8 illustrates a diagram of the computer control system 500 to control the operation of the PTF measurement apparatus 100 according to various embodiments of the present invention. FIG. 8 illustrates that transverse encoder 316, transverse motor 302, position encoder 210, adjustment motor 206, rotation encoder 324, and rotation motor 322 are communicatively coupled to command processor 502. Accordingly, data and commands can be exchanged between encoders 210, 316, and 324, motors 206, 302 and 322, and command processor 510. Command processor 510 is communicatively coupled by communications link 520 with communications network 530. Command processor 510 receives commands from computer 540, and instructs motors 206, 302 and 322 to accordingly turn on or off, read data collected by encoders 210, 316, and 324, or receive initialization information from the "home" or initialization switch of traverse motor 302 and adjustment motor 206. Computer 540 is communicatively coupled using communications link 520 with communications network 530, as is external database 550.

Database 550 can store data obtained measuring sputter targets. Data can include part number, lot number, plate number, target number, applied field, average Gauss, range of Gauss values, lowest Gauss value, highest Gauss value, or average percent PTF, any combination thereof, or any other suitable measurement or data. Database 550 can also store sputter target PTF maps generated by computer 540. Database 550 can store predetermined specifications to be utilized during the measurement of sputter targets. For example, database 550 can store data related to positions on the sputter target where measurements should be made, the number of measurements to be made, the applied field of the magnetic source, the average percent PTF, average Gauss, range in Gauss, any combination thereof, or any other suitable information.

Computer 540 can be a personal computer, laptop computer, mainframe computer, dumb terminal, Personal Digital Assistant (PDAs), wireless terminal, portable telephone, or any other form of networked personal computing device. Computer 540 can include network card 542 for interfacing with communications network 530 to transmit and receive data. Computer 540 can also have processor 544 running a program to control and collect data from transverse encoder 316, transverse motor 302, position encoder 210, adjustment motor 206, rotation encoder 324, rotation motor 322, control processor 510, database 550 or other data storage connected to communications network 530, a magnetic field detector (e.g. magnetic field detector 202, Teslameter 560, magnetic field probe 570, etc.), any combination thereof, or any other suitable device. PTF measurement data, maps of the sputter target, or other suitable data or information can be presented to an operator on display 546.

In the exemplary embodiment illustrated in FIG. 8, computer 540 can be communicatively coupled to Teslameter 560 and magnetic field probe 570, where magnetic field probe 570 reads the magnetic field strength transmitted though the sputter target and Teslameter 560 interprets and quantifies the magnetic field information from the probe, and sends the collected data to computer 540. In other embodiments, Teslameter 560 and magnetic field probe 570 can be combined in a single device as a magnetic field detector, such as magnetic field detector 202 illustrated in FIGS. 1-3 and FIG. 7. In other embodiments, Teslameter 560 can be substituted with a Gaussmeter.

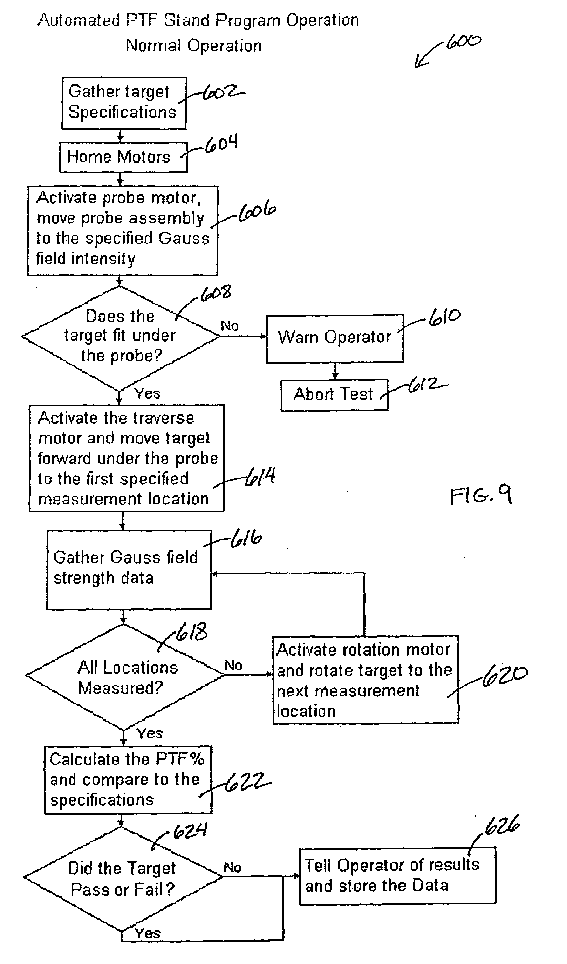

FIG. 9 illustrates automated PTF measurement method 600. Step 602 relates to gathering target specifications, which can be stored in a database (e.g., database 550 of FIG. 8), or can be provided by a customer or operator. The specifications can relate to, for example, the desired PTF characteristics of a sputter target, the number of desired measurements to be made, the locations on the sputter target to measure, the value of the magnetic field to be applied to the sputter target, the acceptable Gauss range for the measured target, the average Gauss value for the measured target, any combination thereof, or any other suitable information. Next, at step 604, traverse motor 302 and adjustment motor 206 are initialized. Each motor has a "home" switch to indicate the start position, which are respectively triggered by the mechanical movement of slide rod bearing assembly 218 along slide rod 220 into at least one predetermined position, or the movement of traverse slide bearing assembly 308 on rotation plate traverse slide 306 to at least one predetermined position. The switches can send a signal to control processor 510 or computer 540 of FIG. 8 to indicate initialization. Traverse encoder 316, position encoder 210, and rotation encoder 324 are also initialized by control processor 510 or computer 540. Next, at step 606, adjustment motor 206 is activated, and magnetic field detector 202 is moved to achieve the specified Gauss field intensity (i.e. magnetic field intensity) that is specified in the database (e.g., database 550), given the intensity of the magnetic field from magnetic source 400. At step 608, computer 540 determines whether target 342 fits under magnetic field detector 202. If it will not fit, the operator is warned at step 610, and the PTF measurement test is aborted at step 612.

If sputter target 342 does fit under magnetic field detector 202, control processor 510 or computer 540 activates traverse motor 302 and moves sputter target 342 under magnetic field detector 202 to the first predetermined measurement location at step 614. Next, at step 616, the magnetic field strength (i.e., Gauss field strength) is gathered by magnetic field detector 202 (or by Teslameter 560 and magnetic field probe 570) and directed to database 550 along communication link 520 to be used by computer 540. At step 618, computer 540 determines if all the predetermined locations for the sputter target have been measured by magnetic field detector 202. If all predetermined targets have not been measured, computer 540 activates rotation motor 322 and drive wheel 318 to rotate sputter target 342 to the next measurement location at step 620, and subsequently returns to gathering gauss field strength data at step 616. If all predetermined locations have been measured, computer 540 calculates the percentage PTF, and then compares this calculation to the specifications that have been established and stored in database 550 at step 622. Next, at step 624, computer 540 determines if the percentage PTF of the measured target meets or fails the stored predetermined specifications in database 550. At step 626, if the target fails to meet the predetermined specifications, the data from the test is stored in database 550. The results (e.g., average PTF, maximum PTF, minimum PTF, target meets specifications, target does not meet specifications, or any other suitable information, etc.) are displayed and the operator is notified. If the target meets the predetermined specification, the data is displayed to the operator.

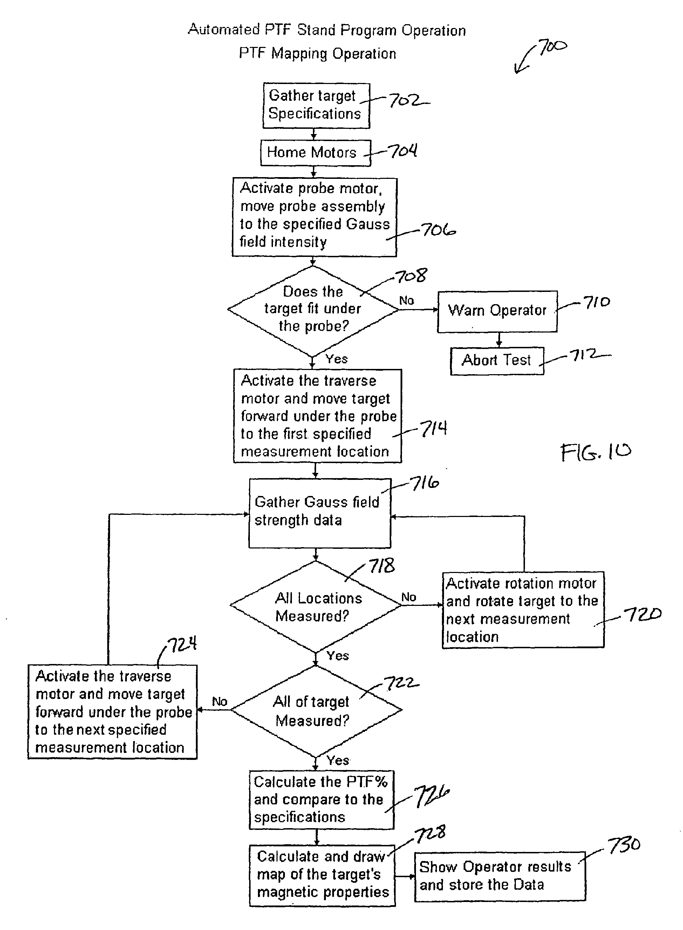

Turning to FIG. 10, method 700 illustrates the PTF mapping operation. In step 702, the target specifications are retrieved from database 550 by computer 540. Next, at step 704, traverse motor 302 and adjustment motor 206 are initialized by control processor 510 or computer 540. Traverse encoder 316, magnetic field detector position encoder 210, and rotation encoder 324 are also initialized by control processor 510 or computer 540. Next, at step 706, adjustment motor 206 is activated by control processor 510 or computer 540, and magnetic field detector 202 (or magnetic field probe 570) is moved in the A or A' direction to achieve the specified magnetic field intensity (i.e., Gauss field intensity) that is stored in database 550 given the applied field of magnetic source 400. In addition, the sputter target is moved into position under the magnetic field detector. At step 708, computer 540 determines whether target 342 fits under magnetic field detector 202. If it will not fit, the operator is warned at step 710, and the PTF measurement test is aborted at step 712.

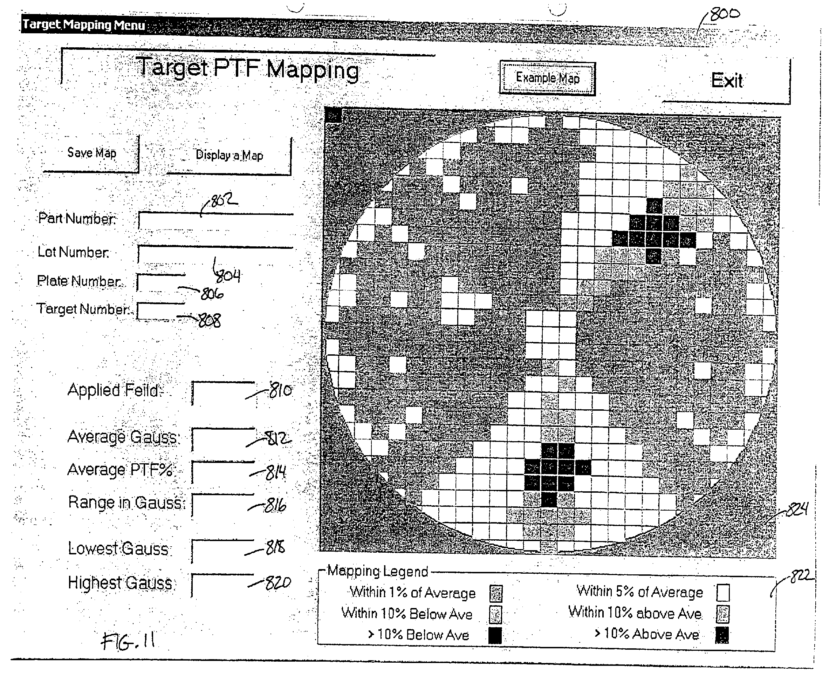

If sputter target 342 does fit under magnetic field detector 202, computer 540 at step 714 actives traverse motor 302 and moves the sputter target under magnetic field detector 202 to the first predetermined measurement location. Next, at step 716, the magnetic field strength (i.e., Gauss field strength) is gathered by magnetic field detector 202 (or magnetic field probe 570) and sent to database 550 along communication link 520. Step 718 determines if all the predetermined locations for the sputter target have been measured by magnetic field detector 202. If all predetermined targets have not been measured, computer 540 at step 720 actives rotation motor 322 and rotates target 342 to the next measurement location, and then returns to step 716 to gather additional magnetic field measurements (i.e., Gauss field strength data). If all locations are measured, computer 540 at step 722 determines if the target has been completely measured. If all of target 342 has not been measured, computer 540 at step 724 activates traverse motor 302 and moves target 342 forward under magnetic field detector 202 to the next specified measurement location, and the method returns to step 716. If all of target 342 has been measured, step 726 calculates the percentage PTF, and then compares this calculation to the specifications that have been established and stored in database 550. Next, at step 728, computer 540 calculates and generates a map of sputter target 342's magnetic properties. At step 730, the map and calculated results are displayed to an operator on display screen 546 connected to computer 540. For example, the sputter target map display can resemble sputter target display screen 800 of FIG. 11.

In one exemplary embodiment for mapping, 128 different positions are measured on a sputter target. Computer controlled PTF stand 100 controls the movement of drive wheel 318 to rotate the sputter target, as well as move rotation plate in the B or B' directions illustrated in FIGS. 4, 6 and 7. In an exemplary embodiment, 16 separate magnetic flux measurements are made along a predefined outer circumferential ring towards the outer edge of a sputter target. These 16 measurements may be equally spaced from each other or at any other suitable distance along the ring, and taken at different degree orientations. Upon completion of these 16 measurements, computer 540 can instruct traverse motor 302 to move rotation plate 304 such that magnetic field detector 202 is positioned away from the outer ring towards the center of the sputter target. Again, 16 measurements are made in a circumferential ring. This process of measuring the sputter target along rings can be done until 128 different measurements are made. The collected measurement data can be stored in a database (e.g., external database 550), and used to create a map (such as the map of sputter target display screen 800 of FIG. 11).

FIG. 11 illustrates an illustrative sputter target display screen 800 that can be presented to an operator according to an exemplary embodiment of the invention. Display screen 800 can present information such as the part number 802 of the sputter target, the lot number 804 of the sputter target, plate number 806, and the target number 808. Command processor 510, which is communicatively coupled via communication links 520 to the magnetic field probe 570 and Teslameter 560 (or a single magnetic field detector device, such as magnetic field detector 202), and to rotation encoder 324, position encoder 210, and traverse encoder 316, can collect data from these devices and calculate and display the applied magnetic field in text box 810, the average Gauss measurement in text box 812, average percent PTF in text box 814, range in Gauss values for the magnetic field measured in text box 816, the lowest Gauss measurement of the magnetic fields measured for a test target in text box 818, and the highest Gauss of the magnetic fields measured for a test target in text box 820. Mapping legend 824 can indicate the averages that a given area of target map 824 are above or below a particular average measurement value.

The detailed description set forth below in connection with the appended drawings is intended as a description of various embodiments of the invention and is not intended to represent the only embodiments in which the invention may be practiced. The detailed description includes specific details for the purpose of providing a thorough understanding of the invention. However, it will be apparent to those skilled in the art that the invention may be practiced without these specific details. In some instances, well known structures and components are shown in block diagram form in order to avoid obscuring the concepts of the invention.

It is understood that the specific order or hierarchy of steps in the processes disclosed is an example of exemplary approaches. Based upon design preferences, it is understood that the specific order or hierarchy of steps in the processes may be rearranged while remaining within the scope of the present disclosure. The accompanying method claims present elements of the various steps in a sample order, and are not meant to be limited to the specific order or hierarchy presented.

The various illustrative logical blocks, modules, circuits, elements, and/or components described in connection with the embodiments disclosed herein may be implemented or performed with a general purpose processor, a digital signal processor (DSP), an application specific integrated circuit (ASIC), a field programmable gate array (FPGA) or other programmable logic component, discrete gate or transistor logic, discrete hardware components, or any combination thereof designed to perform the functions described herein. A general-purpose processor may be a microprocessor, but in the alternative, the processor may be any conventional processor, controller, microcontroller, or state machine. A processor may also be implemented as a combination of computing components, e.g., a combination of a DSP and a microprocessor, a plurality of microprocessors, one or more microprocessors in conjunction with a DSP core, or any other such configuration.

The methods or algorithms described in connection with the embodiments disclosed herein may be embodied directly in hardware, in a software module executed by a processor, or in a combination of the two. A software module may reside in RAM memory, flash memory, ROM memory, EPROM memory, EEPROM memory, registers, hard disk, a removable disk, a CD-ROM, or any other form of storage medium known in the art. A storage medium may be coupled to the processor such that the processor can read information from, and write information to, the storage medium. In the alternative, the storage medium may be integral to the processor.

The previous description is provided to enable any person skilled in the art to practice the various embodiments described herein. Various modifications to these embodiments will be readily apparent to those skilled in the art, and the generic principles defined herein may be applied to other embodiments. Thus, the claims are not intended to be limited to the embodiments shown herein, but is to be accorded the full scope consistent with the language claims, wherein reference to an element in the singular is not intended to mean "one and only one" unless specifically so stated, but rather "one or more." All structural and functional equivalents to the elements of the various embodiments described throughout this disclosure that are known or later come to be known to those of ordinary skill in the art are expressly incorporated herein by reference and are intended to be encompassed by the claims. Moreover, nothing disclosed herein is intended to be dedicated to the public regardless of whether such disclosure is explicitly recited in the claims. No claim element is to be construed under the provisions of 35 U.S.C. §112, sixth paragraph, unless the element is expressly recited using the phrase "means for" or, in the case of a method claim, the element is recited using the phrase "step for."

## Claims

1. An apparatus for determining the pass through flux of a sputter target comprising:
(a) a magnetic source generating a magnetic field passing through the sputter target;
(b) a magnetic field detector configured to measure the magnetic field; and
(c) an automated stand configured to move one or both of the sputter target or the magnetic field detector.

2. The apparatus of claim 1, further comprising a processor in data communication with the magnetic field detector and configured to determine the pass through flux of the sputter target using at least one measurement from the magnetic field detector for at least one location on the sputter target.

3. The apparatus of claim 2, wherein the processor is configured to generate a map of pass through flux of the sputter target.

4. The apparatus of claim 2, wherein the processor is configured to determine at least one of an average Gauss value of the sputter target, a Gauss value range of the sputter target, a lowest Gauss value for the sputter target, a highest Gauss value for a sputter target, or an average PTF percentage, or any combination thereof.

5. The apparatus of claim 4, wherein the processor is configured to generate a map of the sputter target, wherein the map identifies predetermined percentage ranges of the sputter target that are above or below the average Gauss value or average PTF percentage for at least one location on the sputter target.

6. The apparatus of claim 1, wherein the magnetic source is located beneath the sputter target.

7. The apparatus of claim 1, wherein the magnetic source is mounted to a rotatable pedestal.

8. The apparatus of claim 1, wherein the automated stand is configured to rotate the sputter target.

9. The apparatus of claim 8, wherein the automated stand rotates the sputter target to at least one predetermined position, and wherein a processor in data communication with the magnetic field detector and configured to determine the pass through flux of the sputter target using at least one measurement from the magnetic field detector for at least one location on the sputter target at the at least one predetermined position.

10. The apparatus of claim 8, wherein the automated stand retains the sputter target for rotation with at least two idler wheels and a drive wheel above a target table of the automated stand.

11. The apparatus of claim 1, wherein a processor in data communication with the automated stand is configured to move one or both of the sputter target or the magnetic field detector.

12. A method for determining the pass through flux of a sputter target comprising:
(a) generating a magnetic field on a first side of the sputter target and passing the magnetic field through the sputter target and out a second side of the sputter target;
(b) measuring the magnetic field at the second side of the sputter target with a magnetic field detector; and
(c) moving one or both the sputter target or the magnetic field detector during the measuring using an automated stand.

13. The method of claim 12, determining the pass through flux of the sputter target using at least one measurement from the magnetic field detector for at least one location on the sputter target using a processor in data communication with the magnetic field detector.

14. The method of claim 13, further comprising generating a map of pass through flux of the sputter target using the processor.

15. The method of claim 13, further comprising determining at least one of an average Gauss value of the sputter target, a Gauss value range of the sputter target, a lowest Gauss value for the sputter target, a highest Gauss value for a sputter target, or an average PTF percentage, or any combination thereof using the processor.

16. The method of claim 15, further comprising generating a map of the sputter target using the processor, wherein the map identifies predetermined percentage ranges of the sputter target that are above or below the average Gauss value or average PTF percentage for at least one location of the sputter target.

17. The method of claim 12, wherein the magnetic source is located beneath the sputter target.

18. The method of claim 12, wherein the magnetic source is mounted to a rotatable pedestal.

19. The method of claim 12, wherein the automated stand is configured to rotate the sputter target.

20. The method of claim 19, further comprising rotating the sputter target to at least one predetermined position using the automated stand, and determining the pass through flux of the sputter target using at least one measurement from the magnetic field detector for at least one location on the sputter target at the at least one predetermined position using the processor.

21. The method of claim 19, further comprising retaining the sputter target for rotation with at least two idler wheels and a drive wheel above a target table of the automated stand.

22. The method of claim 11, configuring a processor in data communication with the automated stand to move one or both of the sputter target or the magnetic field detector.
